Europäisches Patentamt

European Patent Office

Office européen des brevets

(19)

(11) **EP 0 759 640 B1**

(12) **EUROPEAN PATENT SPECIFICATION**

(45) Date of publication and mention
of the grant of the patent:
**11.06.2003 Bulletin 2003/24**

(51) Int Cl.⁷: **H01L 29/15**, H01L 29/88

(21) Application number: **96113185.1**

(22) Date of filing: **16.08.1996**

(54) **Semiconductor superlattice oscillator and methods of manufacturing and operating the same**

Halbleiter-Übergitter-Oszillator und Verfahren zur Herstellung und zum Betrieb

Oscillateur à super-réseau semi-conducteur et méthodes de fabrication et d'utilisation

(84) Designated Contracting States:
**DE FR GB NL**

(30) Priority: **17.08.1995 EP 95112956**

(43) Date of publication of application:
**26.02.1997 Bulletin 1997/09**

(73) Proprietor: **Paul-Drude-Institut für
Festkörperelektronik
10117 Berlin (DE)**

(72) Inventors:
• **Kastrup, Jörg
81825 München (DE)**
• **Grahn, Holger Theodor
10117 Berlin (DE)**

(74) Representative: **Morgan, James G. et al
Manitz, Finsterwald & Partner GbR
Postfach 31 02 20
80102 München (DE)**

(56) References cited:
**US-A- 3 626 257**    **US-A- 3 626 328**

• ELECTRONICS LETTERS, vol. 27, no. 12, 6 June 1991, STEVENAGE GB, pages 1101-1103, XP000237782 M. HADJAZI ET AL.: "Negative differential conductance in GaAs/AlAs superlattices"
• ANNALEN DER PHYSIK, vol. 4, no. 3, 19 April 1995, GERMANY, pages 184-190, XP000609289 J. GRENZER ET AL.: "Mictowave oscilator based on Bloch oscillations of electrons in a semiconductor superlattice"
• JAPANESE JOURNAL OF APPLIED PHYSICS, vol. 25, no. 5, May 1986, TOKYO JP, pages L349-L351, XP002018315 N. IWATA ET AL.: "DX center-like trap in selectively doped Si-doped AlAs/GaAs superlattices"
• ELECTRONICS LETTERS, vol. 29, no. 8, 15 April 1993, STEVENAGE GB, pages 648-649, XP000363864 M. HADJAZI ET AL.: "60GHz reflection gain based on superlattice negative differential conductance."
• APPLIED PHYSICS LETTERS, vol. 60, no. 19, 11 May 1992, NEW YORK US, pages 2397-2399, XP000275890 H. LE PERSON ET AL.: "Gunn oscillations up to 20 GHz optically induced in GaAl/AlAs"

## Description

The invention relates to a semiconductor superlattice oscillator, to a method of manufacturing a semiconductor oscillator and to a method of operating a semiconductor superlattice oscillator.

A large number of different constructional principles exist for oscillators, particularly in the frequency range below 1 GHz. Above 1 GHz oscillators are available which are based on the Gunn-effect. Here the tuning takes place principally via the length of the oscillator element. The Gunn-effect is commonly associated with the generation of high frequency radiation by travelling dipole domains. This is indeed the dominant mechanism for long Gunn diodes (on the order of $10\mu m$) operating at low frequencies, say a few GHz. However, these dipole solutions have little practical importance nowadays because at low frequencies Gunn diodes are replaced by transistors. In existing microwave applications of Gunn-diodes the dominant mode is a travelling accumulation layer mode. To form such accumulation layers the diode needs to have a certain minimum length because the electrons must be accelerated before they can make a transfer to higher valleys. Because the acceleration region mainly acts as a series resistance which dissipates power, this reduces the efficiency of the Gunn diodes.

Double barrier resonant tunnelling diodes (DBRTs) are also used for high frequency oscillations and indeed currently hold the record for high-frequency generation. They are characterised by low output power and low noise.

IMPATT diodes so far deliver the greatest power of all diode generators (i.e. several watts in the microwave range). However, due to the avalanche multiplication process the noise of the injected current is multiplied by the same factor as the current. Additionally, the multiplication process itself is of stochastic nature and adds extra noise. Gunn diodes are also known for having rather high noise levels, due to the inevitably high carrier temperature which is necessary for scattering into higher valleys of the band structures.

There are two patent applications, namely DE-AS 20 08 043 and DE-AS 20 14 677 which propose a semiconductor oscillator with a superlattice structure and operate by transport in the miniband. An oscillator of this kind is termed an electrically operated Bloch oscillator. Damped field oscillations as a result of the miniband negative differential velocity have been found by Le Person et al. (Appl. Phys. Lett. 60, 2397 (1992)). Amplification in the miniband region was proved by Hadjaz et al. (Electron. Lett. 29, 648 (1993)) up to 60 GHz.

A superlattice structure according to the preamble of claim 1 is known from Hadjazi et al. (Electron. Lett. 27(12), 1101-1103 (1991)). This superlattice structure is of the same type as the ones by Le Person et al. and Hadjaz et al. mentioned above.

A further oscillator based on Bloch oscillations of electrons in a semiconductor superlattice is described by J. Grenzer et al. (Ann. Physik 4, 184-190 (1995)). This superlattice structure is also similar to the ones by Le Person et al. and Hadjaz et al. mentioned above.

More specifically, DE-AS 20 08 043 and the closely related DE-AS 20 14 677 are concerned with the coherent oscillation of charge carriers.

Essential for the realisation of this principle is that the discrete energy levels in a superlattice structure are broadened by the coupling of adjacent wells resulting from the barrier thickness and a sufficient number of periods of the superlattice to form so-called minibands in real space.

The carriers are expected to oscillate in momentum space (K-space) as a result of a small applied field. This field must be sufficiently small that, for the particular component and its parameters, no Stark localisation of electrons occurs, i.e. the minibands do not split up into discrete levels for each quantum well. It is fundamental for the Bloch oscillator that the electric field is constant inside the superlattice structure. This is, however, only the case when no excess charge carriers are present. This is a dilemma and explains why oscillators of this kind have not been commercially realised. The dilemma is as follows:

The injection of excess carriers in combination with the existence of negative differential velocity means that small concentrations of carriers are amplified and lead to inhomogeneous fields so that the minibands are destroyed and the Bloch oscillation either does not start or dies away immediately. The principle of this oscillator has only been proved by optical excitation of coherent wavepackets using a laser and by observing the transient decaying oscillation. It has not proved possible to build a purely electrically driven oscillator of this kind with sustained or transient oscillations.

The object of the present invention is to provide a universally applicable novel constructional principle for oscillator elements. In particular the principle should make it possible to realise oscillator elements having frequencies in a large frequency range from a few Hz up to a few hundred GHz by the freedom provided by the principle in the choice of parameters such as the barrier thickness, quantum well thickness, doping and length of the samples of the oscillator elements.

More specifically it is an object of the present invention to provide a semiconductor superlattice oscillator which can operate at frequencies approximately up to and comparable with those of double barrier tunnelling diodes but with a significantly higher output power and at very low noise levels considerably superior to those of IMPATT diodes. Moreover, the frequencies obtainable and the efficiencies should be respectively higher and considerably better than the values which can be obtained with Gunn diodes.

In order to satisfy this object the present invention provides a semiconductor superlattice oscillator comprising a semiconductor substrate having, in sequence, a first N-layer deposited directly or indirectly on the substrate, a superlattice structure comprising alternating pairs of semiconductor layers of materials of first and second band gaps deposited on said N-layer, there being preferably a minimum of ten and in particular more than twenty such layer pairs, and a second N-layer deposited on said superlattice structure (further layers being optionally also possible), there being first and second means for contacting said first and second layers respectively, characterised in that the superlattice layers are of a thickness such that energy quantisation in the form of subbands and resonant tunnelling between subbands of adjacent well layers takes place; and in that the doping density in the well layers is selected so that sustained oscillations of the field distribution inside the superlattice structure, and thus of the output current, occur.

The invention is thus based on the concept of an oscillator element which functions on the basis of resonant tunnelling in semiconductor superlattice structures. The oscillation frequency depends on the tunnelling time through the barriers of the superlattice and on the number of periods (i.e. to the length of the device) and can be varied over a wide range from the kHz range up to several hundred GHz. These intrinsic frequencies can, moreover, be tuned through certain ranges within a system by variation of the applied voltage. For various subband resonances frequencies result which increase with the coupling strength. Responsible for the oscillations are field inhomogeneities which arise through the oscillator elements and which arise as a result of the strongly non-linear transmission characteristic due to the resonant tunnelling.

In contrast to the superlattice Bloch oscillator of DE-AS 20 08 043 the present invention exploits travelling field inhomogeneities to produce a high quality (high Q-factor), electrically stimulated, sustained oscillation of tunable frequency. The oscillator of the present invention is based on the realisation that an alternative type of oscillation is possible, determined by the transit time of electrons through the whole structure. This transit time is determined by the length of the superlattice structure and the average drift velocity of the carriers which can be modulated by the externally applied voltage. For this to be achieved it is necessary for the 2D-doping density in the well layers to lie within certain limits. Above the upper limit static inhomogeneous field domains arise and the effect of the present invention is not observed. Below the lower limit broad undefined inhomogeneities arise and the effect is again no longer present. Stable inhomogeneous field oscillations only occur between these limits.

Unfortunately the precise doping density cannot be given as a numerical value since it depends on the barrier width, the well width, the temperature, the sample quality, the sample length and the composition which determines the barrier height. It is, however, possible to give a guide to the selection of the required doping density. It is known that an accumulation of electrons occurs at an electrical field discontinuity, i.e. at positions where the field is not constant. The doping density should be chosen such that the 2D electron accumulation layer between the two fields is larger than the doping density by a factor of the order of 5 : 100. It cannot, however, be ruled out that with some structures the optimum will be found outside of this range. A rule of thumb of the determination of the doping density is as follows:

First of all reference is made to the Gaussain Law which can be written as

$$n_{2d} = \varepsilon_o \; \varepsilon_r \; \frac{\Delta F}{e}$$

where

$n_{2d} =$ the density of the two dimensional electron accumulation layer at the field discontinuity

$\varepsilon_o =$ the permittivity of free space

$\varepsilon_r =$ the relative permittivity of the sample and

$e =$ the electronic charge.

$\Delta F$ is a value for the electric field difference and is given by the equation

$$\Delta F = \frac{E_2 - E_1}{ed}$$

where $E_2$ and $E_1$ are the two lowest subband energy levels in the quantum wells and d is the periodic length of the superlattice structure (i.e. of a well layer plus a barrier layer). $E_2$ and $E_1$ can readily be calculated using the Schroedinger wave equation. Following this method one can obtain the doping density required to obtain oscillation in the lowest plateau of the current voltage characteristic.

The doping density $N_{2d}$ required in the well layers can then be estimated using the rule of thumb

$$N_{2d} = n_{2d} \; /(5 \text{ to } 80)$$

One particularly important advantage of the semiconductor superlattice oscillator of the present invention is that it is tunable over a large frequency range in a very simple manner, namely by a variation of the applied potential difference. The invention can thus be used as a tunable oscillator. Through a suitable choice of the parameters, in particular of the barrier thickness, it is possible to manufacture electrically tunable oscillators in the kHz, MHz or GHz range.

This simple tunability should be contrasted with, for example, Gunn diodes. Here the oscillator frequency is set by incorporating the diode into an oscillator circuit, measuring the frequency of the oscillation, ablating the diode by a laser while in operation to change its length and its frequency of oscillation. Once this process is completed the frequency of oscillation is fixed.

Moreover, the temperature dependence of the tuning curve permits the generator to be used as a temperature sensor. The temperature can be read off from a calibration curve relating the frequency generated to a specific predetermined potential difference.

In the miniband oscillators proposed in the two German references cited above, the content of which is incorporated into the present application by reference, measures are taken to avoid tunnelling effects as far as possible. In contrast, the present invention recognises that resonant tunnelling can be used to produce an extremely effective semiconductor oscillator. In distinction to the miniband oscillators proposed in the German references cited above the present invention exploits periodically returning field inhomogeneities in the superlattice which form the basis for the current oscillation - in similar manner to the Gunn effect. The field inhomogeneities are generated by the non-linear transmission characteristic v(F) of the superlattice, in particular in the region of negative differential conductivity (NDV). In contrast to the Gunn effect it is, however, not the Torr-X transfer, which is difficult in influence, which is responsible for the non-linearity, but rather the tunnel resonances between different subbands in adjacent quantum wells. These tunnel resonances can be varied in position and shape over wide ranges through choice of the barrier thickness and quantum well width. Thus the frequency of the oscillator element can be changed very simply. Furthermore, in superlattices with a plurality of subbands a plurality of tunnel resonances arise. Since the frequency of the oscillation can change by orders of magnitude from one tunnel resonance to the next, the possibility is given of operating the oscillator element in very different frequency ranges. Furthermore, first measurements show that the oscillation frequencies in the region of a given tunnel resonance can be continuously tuned over a certain range through variation of the operating potential. This can only very restrictedly realised in existing oscillators, in particular in the GHz range.

As further background to the present invention a discussion will now follow of the observation of self-sustained oscillators associated with electric field domains in GaAs/AlAs superlattices. The samples are n-doped superlattices embedded between $n^+$ contacts. The observed oscillation frequencies between 700 kHz and 100 MHz depend strongly on the coupling strength between adjacent wells. Monitoring the oscillations with time-resolved photoluminescence spectroscopy indicates that the current oscillations are due to the movement of a charge accumulation layer at the domain boundary. the followin discussion includes references, using numbers in square brackets, to earlier publications which are listed at the end of the description.

The present invention will now be described in further detail with reference to preferred embodiments and to the accompanying drawings in which are shown:

Fig. 1A a sketch illustrating a semiconductor superlattice component in a circuit for the generation of oscillations ,

Fig. 1B a table giving full details of the semiconductor superlattice component structure shown in Fig. 1A,

Fig. 2 I-V characteristics of two GaAs-AlAs superlattices with 13.3 nm (9.0 nm) GaAs well and 2.7 nm (4.0 nm) AlAS barrier widths at 5 K, with the 13.3/2.7 sample being the one recited in Fig. 1B,

Fig. 3 current vs. time at 5 K; data for the 9/4 sample are shown in (a) (lower plateau) and (b) (upper plateau); (c) data for the 13.2/2.7 SL,

Fig. 4 a Fourier transform of the oscillations shown in Fig. 3 (c).

Fig. 5 (a) comparison between the time-integrated PL spectrum at zero field and time-resolved PL spectra corresponding to the oscillation in Fig. 3(b); (b) schematic potential distribution at two different times during one period of the oscillations shown in Fig. 3(b) and 5(a); the domain wall is indicated by full circles,

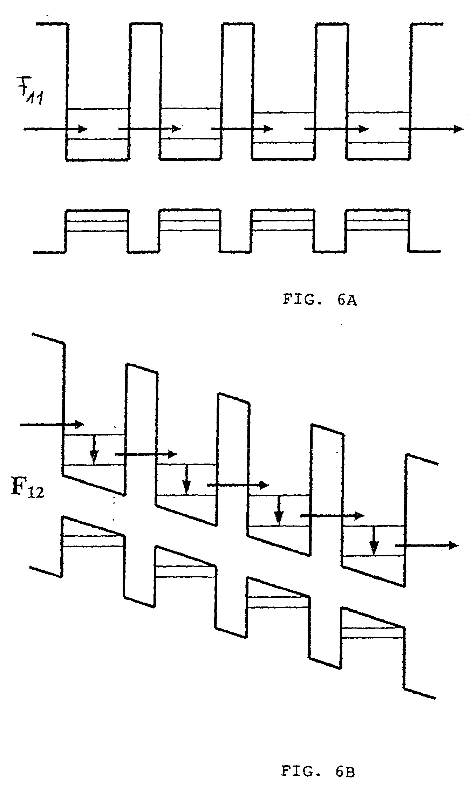

Fig. 6A,B two sketches to illustrate the formation of subband resonances in a superlattice structure in a homogenous field. Fig. 6A shows a first subband resonance $F_{11}$ in which the first subband of each well is at resonance with the first subband of the next well, which is only possible at small fields. Fig. 6B shows a second subband resonance $F_{12}$ (higher field) between the first subband resonance of each well and the second subband of the next well.

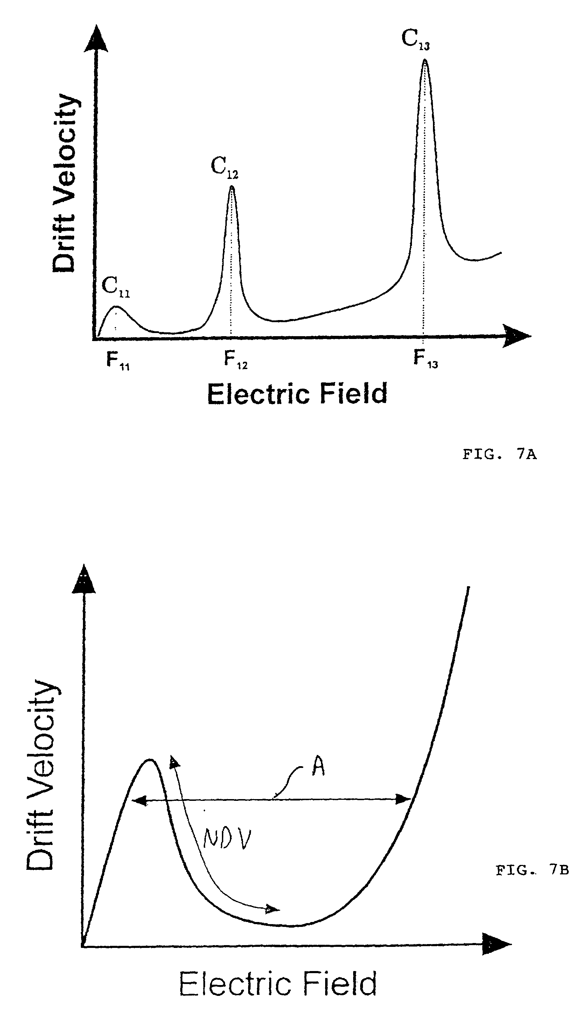

Fig. 7A,B a plot (7A) showing the average drift velocity of a superlattice with three subband resonances for homogeneous fields. Fig. 7B shows an enlarged section of Fig. 7A to illustrate the region of negative differential velocity (NDV) andthe region A in which oscillations are observed.

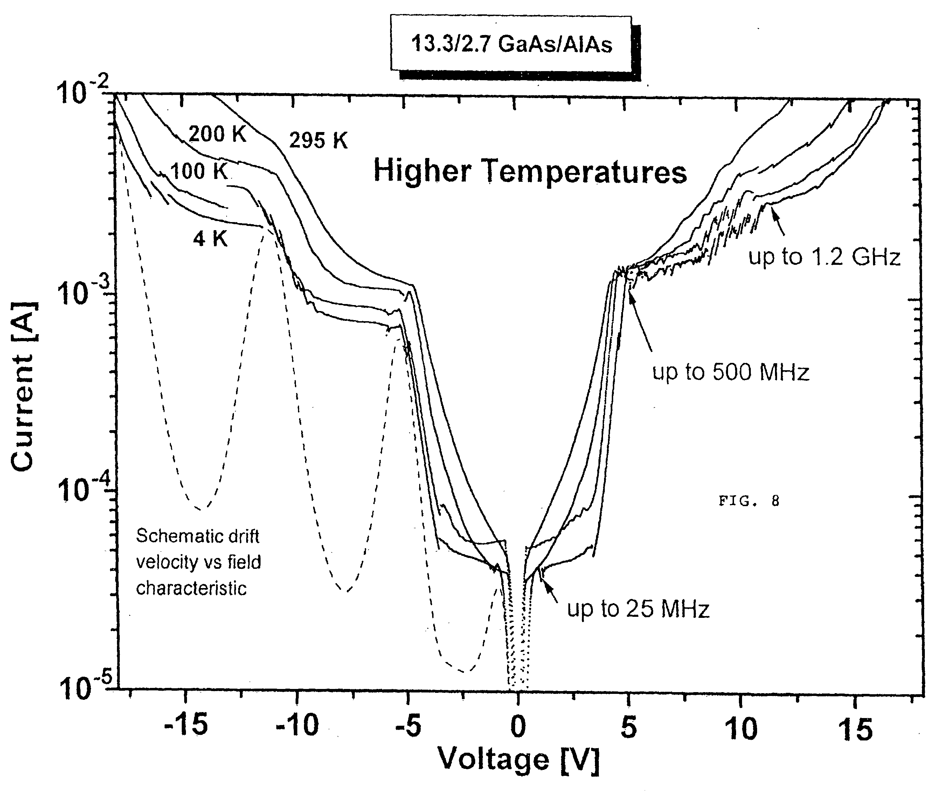

Fig. 8 is a graph similar to that of Fig. 2 for a specific semiconductor oscillator having a superlattice comprising 50 periods of alternating GaAs/AlAs layers of 13.3 nm and 2.7 nm thickness respectively, with the Figure in particular showing the I-V characteristics of the oscillator for four different temperatures (4° K, 100° K, 200° K and 295° K) and additionally showing in broken lines the theoretical drift velocity versus field characteristic for homogeneous fields,

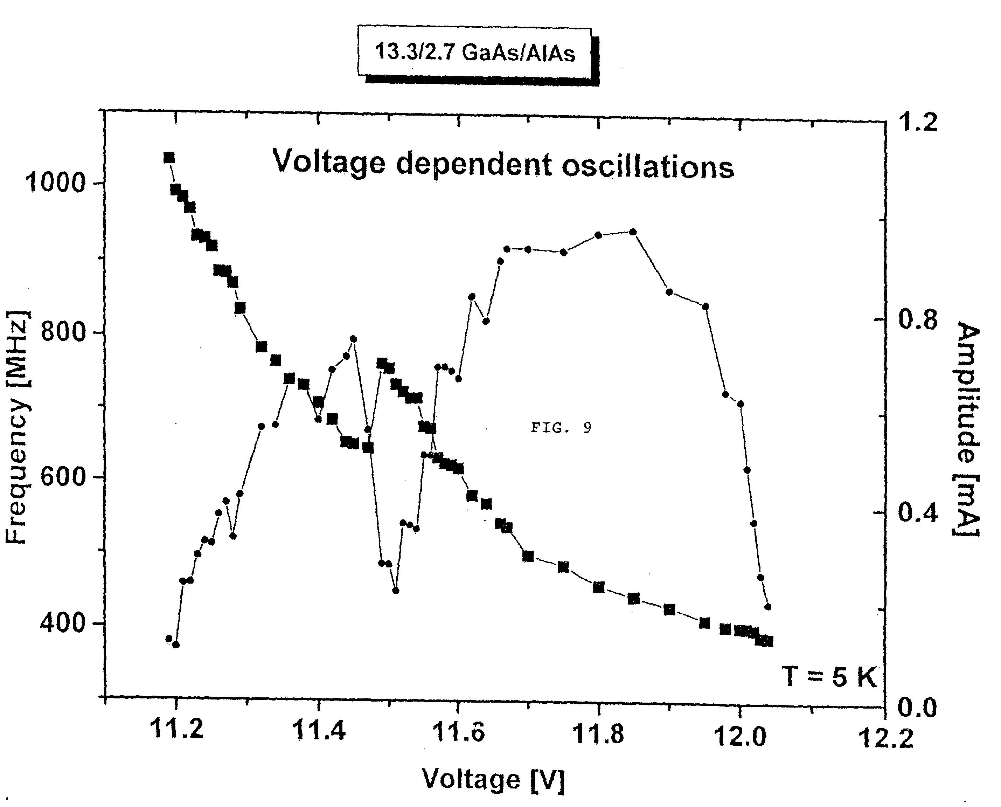

Fig. 9 shows the voltage dependent oscillatory behaviour of the sample measured to produce the graph of Figure 8 at 5° K, with the line joining the square points showing the voltage dependence of the frequency and the line joining the round points showing the voltage dependence of the amplitude of the oscillation,

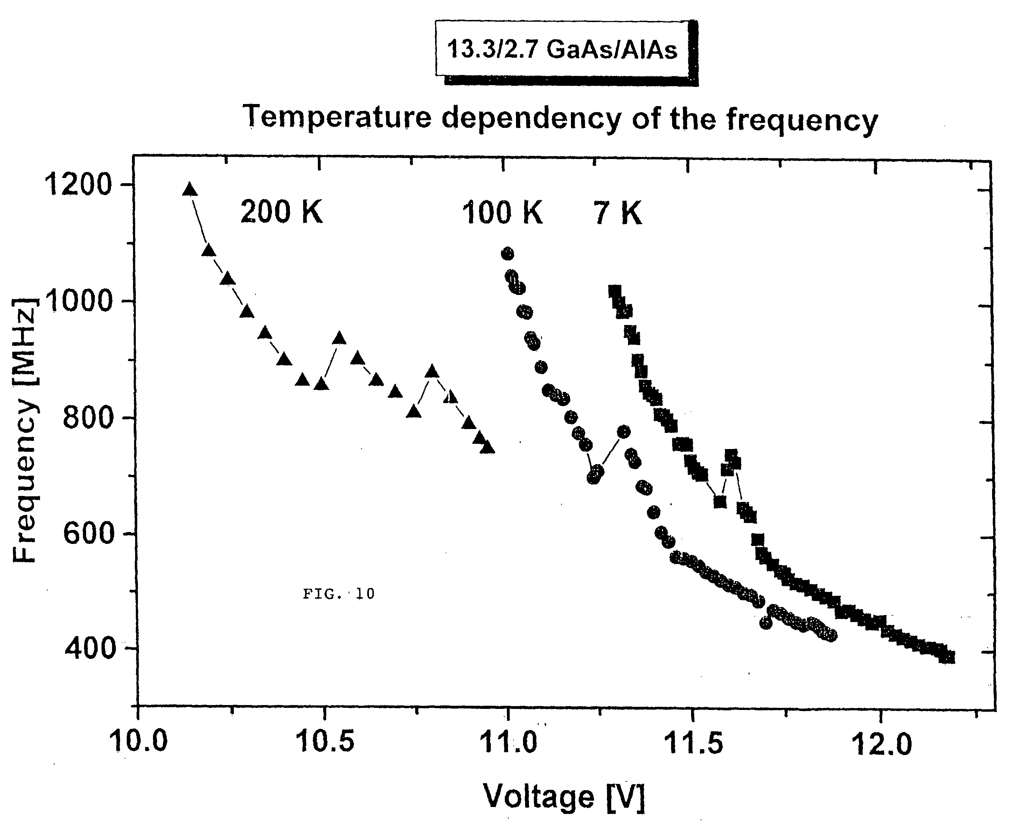

Fig. 10 a plot showing the temperature dependency of the frequency of oscillation for the same sample as used for Figure 8, and

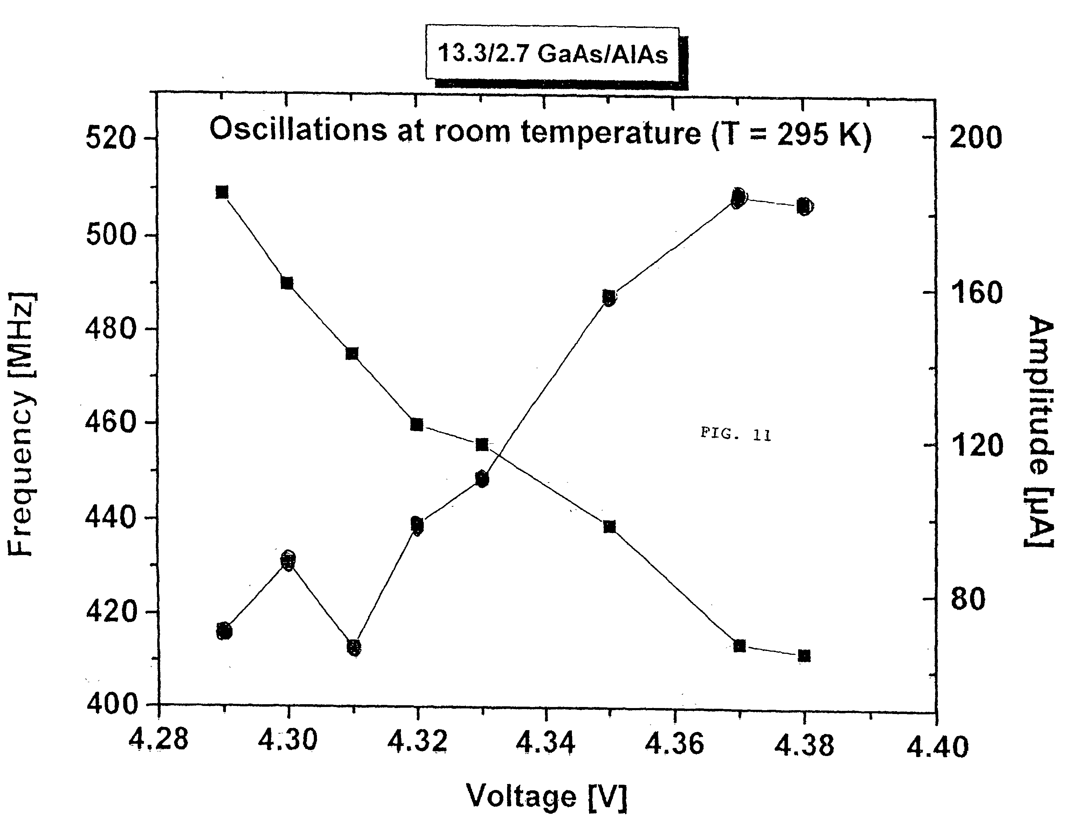

Fig. 11 shows that oscillations are is obtained at room temperature and are tunable through a range of frequencies. The plot with square points refers to the frequency and the plot

Oscillatory behaviour in semiconductor materials is known to occur as a consequence of negative differential velocity (NDV). The best understood mechanism leading to NDV in III-V materials such as GaAs, InGaAs or InP is intervalley transfer from the r minimum to the X and L valleys. [1] Gunn's experimental observation of the current oscillations in 1963 [2] pushed high frequency oscillators to new limits in the GHz regime opening up a new field in semiconductor physics. Entirely different mechanisms leading to NDV were proposed by Esaki and Tsu [3] based on miniband transport and by Kazarinov and Suris [4] based on resonant tunnelling in GaAs/AlAs superlattices (SLs). However, instead of self generated oscillations only stable electric field domains were found [5]. Recently, damped oscillations in response to optical excitation have been observed by several groups [6-8].

In the following discussion the observation of self-sustained oscillations in semiconductor SLs due to resonant tunnelling will be presented. Time-resolved photoluminescence (PL) measurements demonstrate that the oscillations are due to the motion of charge accumulated at the domain boundary between two electric field domains. The frequency of the oscillation depends strongly on the barrier widths and, thus, on the tunnelling times.

In highly doped GaAs/AlAs superlattices stable electric field domains form as a result of NDV associated with resonant tunnelling. Depending on the SL parameters, several subbands may be present leading to several tunnelling maxima in the drift velocity vs field (v(F)) characteristics. This is in sharp contrast to the Gunn effect, which relies on a single NDV region due to intervalley scattering. At voltages between the resonant tunnelling maxima the electric field splits up into two domains with a layer of accumulated electrons forming the boundary. With increasing bias voltage the boundary steps through the superlattice well by well, leading to a series of abrupt jumps in the I-V characteristics. At low doping densities the domain regime ceases to be stable and self-generated oscillations occur. The oscillations are attributed to a periodic motion of the domain boundary over a few periods of the superlattice. Unlike for the Gunn effect, where the propagation speed is limited by the intervalley scattering time, the speed of the propagating charge accumulation layer in the SL is limited by the tunnelling time. Accordingly, the frequency of the oscillation increases with increasing tunnelling probability from a few hundred kHz into the MHz region.

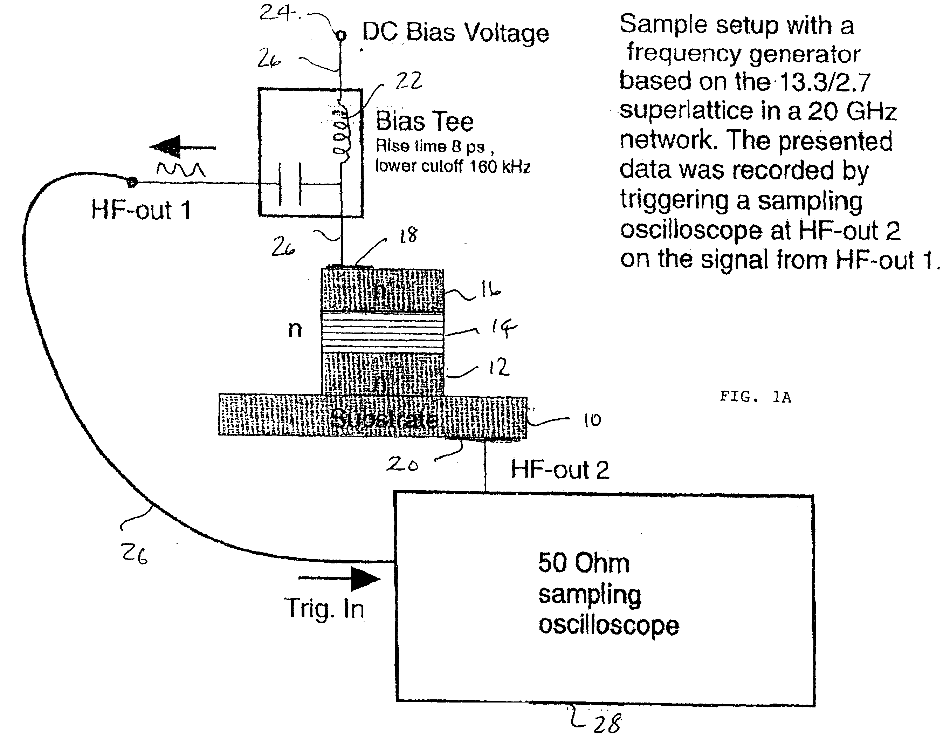

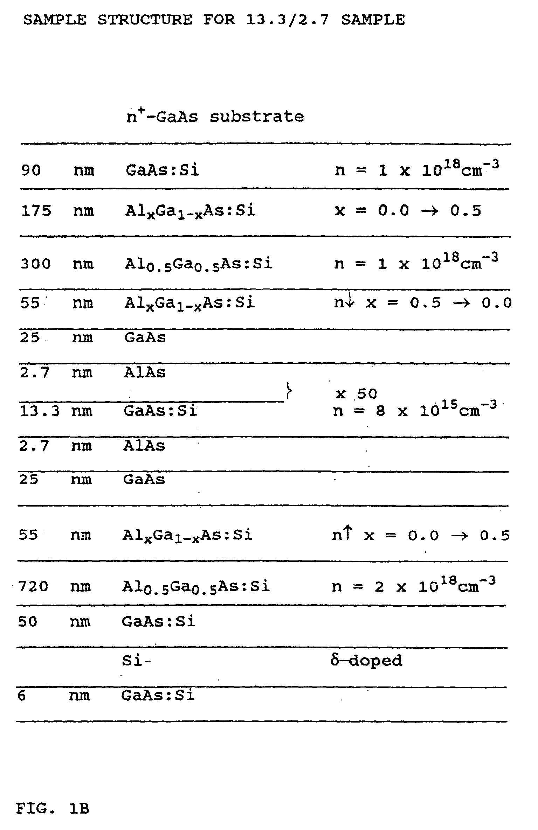

Two SL samples will now be discussed, hereafter referred to as 9/4 and 13.3/2.7 according to their SL parameters. The samples are schematically illustrated in Fig. 1A and the detailed composition of the 13.3/2.7 sample is set forth in the table of Fig. 1B. More specifically, Fig. 1A shows an $n^+$ GaAs substrate 10 on which there is first deposited a buffer layer (not shown) comprising 90nm of Si-doped GaAs with $n = 1 \times 10^{18} cm^{-3}$. On this there is then deposited an n-type silicon doped layer 12 of AlGaAs of graded composition which actually comprises a 175 nm thick Si-doped $Al_xGa_{1-x}As$ layer in which x is varied from 0.0 to 0.5, a 300 nm thick $I_{0.5}Ga_{0.5}As$ layer doped with silicon with $n = 1 \times 10^{18} cm^{-3}$, a 55 nm thick gradient composition $Al_xGa_{1-x}As$ layer in which the doping concentration is progressively reduced to zero and in which the value of x is reduced from 0.5 to 0.0. On top of this layer there is then formed an undoped GaAs spacer of 25 nm thickness.

On top of this spacer there is then formed a superlattice 14 comprising 50 periods of a structure comprising alternating barrier layers of 2.7 nm thick undoped AlAs and 13.3 nm thick well layers of GaAs which are doped with silicon at a doping density of $n = 8 \times 10^{15} cm^{-3}$. This superlattice is followed by a 2.7nm AlAs undoped layer for symmetry reasons, which is usual when growing superlattices. On top of this layer there is then grown a further 25nm undoped GaAs layer, again for reasons of symmetry.

The two last named layers are not shown in Fig 1A they are however followed by a further $n^+$ layer 16 which actually comprises in sequence, a 55 nm thick graded composition $Al_xGa_{1-x}As$ layer doped with Si in which x changes from zero at the boundary to the GaAs layer to 0.5, and in which n increases to $2 \times 10^{18} cm^{-3}$, a 720 nm thick $Al_{0.5}Ga_{0.5}As$ layer doped with Si at a doping density of $n = 2 \times 10^{18} cm^{-3}$, a 50 nm GaAs layer, a δ doped Si layer (i.e. an Si monolayer) followed by 6 nm GaAs.

A second sample was grown with a superlattice having forty periods of 4 nm thick barrier layers and 9 nm thick well layers in the same material system. The two-dimensional doping density inside the GaAs wells was $n_{2d}$ = $1.5 \times 10^{11}$ cm$^{-2}$.

The samples were processed by wet etching into mesas of 120 $\mu$m diameter (9/4) and 200 $\mu$m diameter (13.3/2.7). For electrical connections AuGe/Ni contacts 18, 20 evaporated on top and on the substrate side. The circular top contacts of 70 $\mu$m diameter leave a large part of the mesas uncovered to allow for optical access. All experiments were performed at 5 K in a He-Flow cryostat with high frequency coaxial cables with a bandwidth of 20 GHz. The current voltage traces were recorded using a Hewlett Packard (HP) 3245A voltage source and a HP3458A multimeter to measure the time averaged current. The time-resolved current was detected with a Tektronix sampling oscilloscope CSA 803 using the GHz sampling head SD-32.

Oscillations have also been succesfully observed in InGaAs/InAlGaAs and are also expected in other material systems.

The samples are incorporated into an oscillator circuit, for example, as shown in Fig. 1B. The choke 22 is simply provided to isolate the oscillator from the voltage source 24 and is dimensioned so that it no longer transmits the lowest frequency of interest. The connection lines 26 used have 50 Ohm impedance for matching to the 50 Ohm input impedance of the attached circuit which comprises a sampling oscilloscope 28 in this test arrangement. All the cables used were 50 Ohm SMA cables with a maximum frequency of 20 GHz.

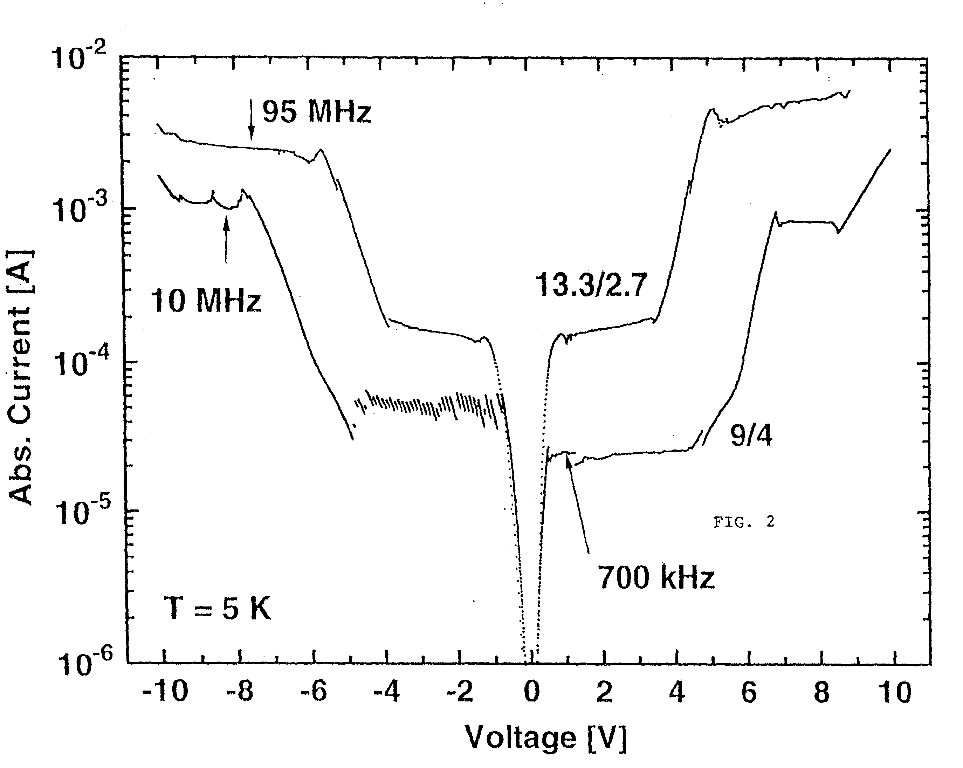

Fig. 2 shows the current voltage (I-V) characteristics of the two samples at 5° K. Both structures exhibit two plateau regions in forward (+) and reverse (-) bias (here, forward denotes positive voltage at the top contact on the mesa so that the electrons are injected from the substrate side). The lower and upper plateaus begin at the current maximum corresponding to, respectively, tunnelling between the lowest subbands of adjacent wells (C1-C1 tunnelling) and C1-C2 tunnelling ($C_i$ denotes the $i$th electronic subband). For details on the plateau formation see [9, 10]. While the lower plateau of sample 9/4 in reverse bias shows the well understood series of current branches [11], all other plateaus are more or less flat revealing no direct sign of domain formation. Particularly interesting is the unexpected asymmetry in the I-V characteristic of sample 9/4, which is inconsistent with the symmetric growth sequence (n$^+$-n-n$^+$ diodes).

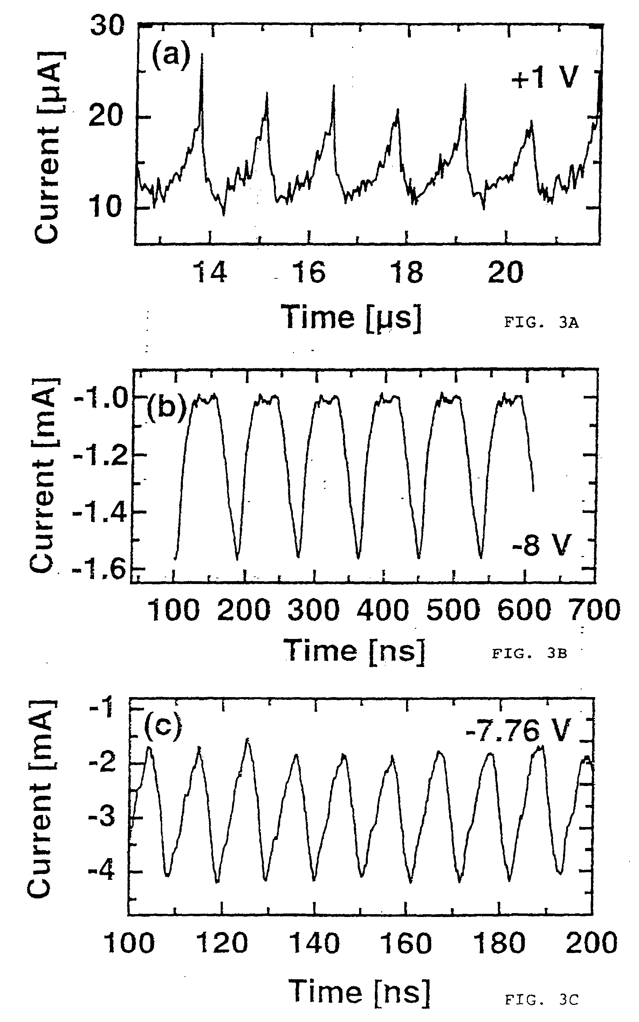

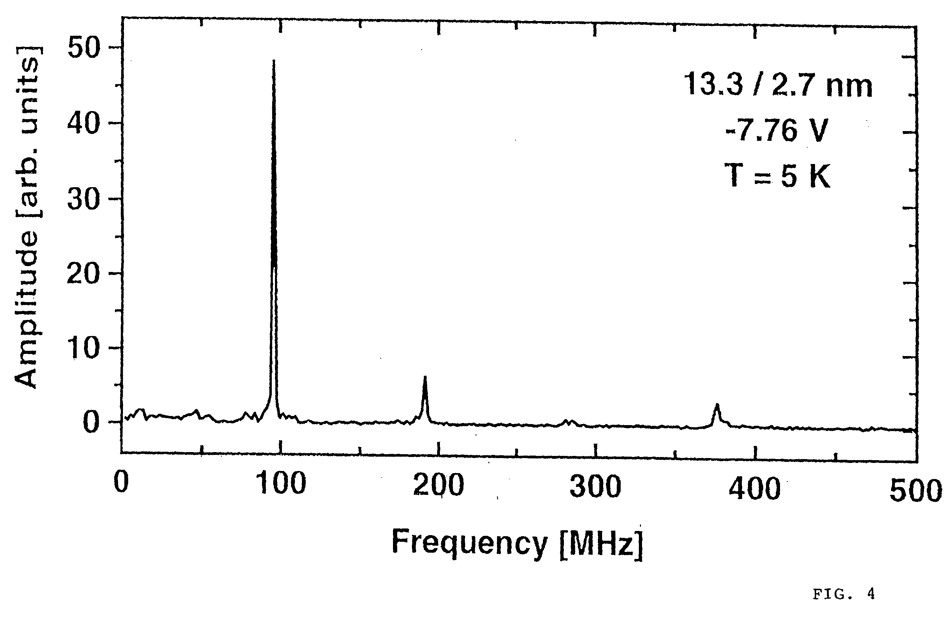

The oscilloscope traces shown in Fig. 3 reveal that the current in the plateau regions oscillates. Fig. 3 (a) shows oscillations in sample 9/4 at +1 V. In this plateau the current oscillates at approximately 700 kHz, but the frequency increases to about 10 MHz in the upper plateau as shown in Fig. 3(b). This increase is due to the fact that the transmission probability at -8 V is governed by the C1-C2 tunnelling resonance which is much stronger than that for C1-C2, which controls the current in the lower plateau. Consistent with this interpretation, the current shown in Fig. 3(c) oscillates at an even higher frequency because the thinner barriers (2.7 nm) give rise to much shorter tunnelling times. The Fourier transform for the data shown in Fig. 3(c) is plotted in Fig. 4. Other than the fundamental frequency peak at 95 MHz a series of higher harmonics appear, indicating that the oscillation is not simply sinusoidal. Detailed investigations of the transport behaviour in the upper plateau of sample 9/4 show that, both oscillating and static domains, may exist within one plateau. For example, the current at the small peak at -8.6 V for the 9/4 sample has no ac component, while it oscillates at slightly higher and lower voltages. It will be apparent to a skilled reader from Fig. 4 that the oscillation is very sharp, i.e. has an extremely high Q-factor.

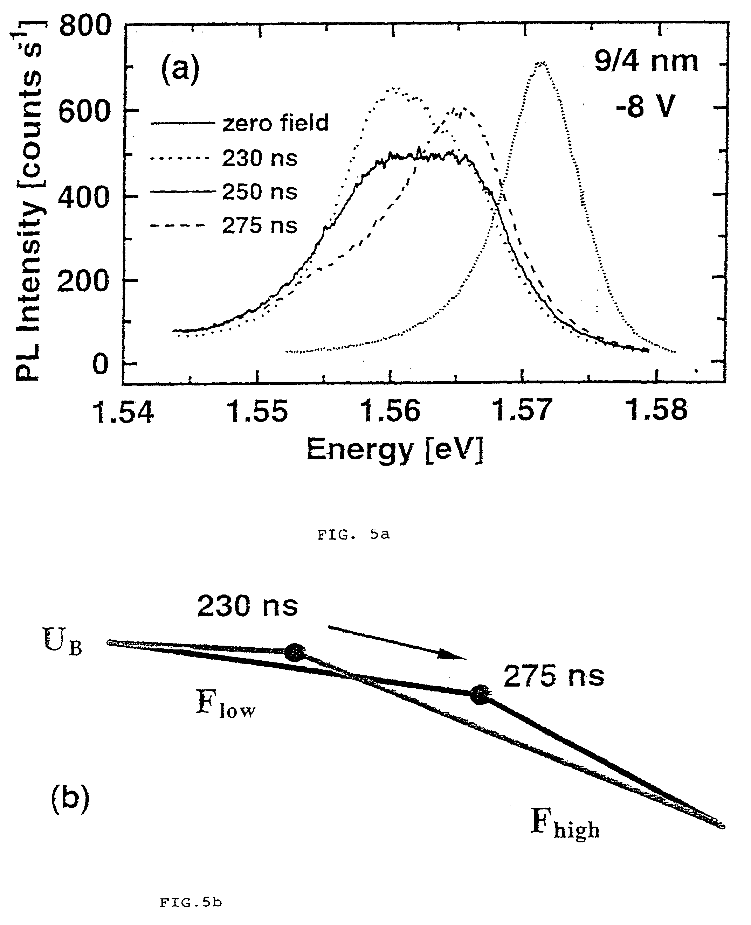

Fig. 5(a) shows the zero-field and time-resolved PL spectra exhibiting a peak due to the recombination of electrons with heavy holes. Due to the quantum confined Stark effect, the PL emission from the quantum wells in an electric field shifts to the red with increasing field. Hence, measurements of the PL energy allows one to estimate the field strength in the superlattice. A Stark-splitted PL line indicates that there are two different field strengths present inside the SL [12]. Since the intensity of the emission is proportional to the length of the corresponding field domain, it is possible to obtain a rough estimate of this value. In experiments carried out by the inventors the excitation density was chosen, to be sufficiently small that the current oscillation was not perturbed. The time-resolved PL spectra shown in Fig. 5(a) were recorded at -8 V by triggering the streak camera on the current oscillation of Fig. 3(b). It should be noted that the time-resolved spectra are red-shifted with respect to the zero-field PL line indicating that a strong electric field is acting on the SL. The spectrum at 230 ns (peaked at 1,560 eV) and the spectrum at 275 ns (peaked at 1,565 eV) correspond to the current minima and maxima respectively. The trace at an intermediate time (250 ns) displays emission from both domain regions manifesting itself in the broader lineshape. The results indicate that the high-field domain is dominant at 230 ns, while the low-field domain has its greatest spatial extent at 275 ns. This behaviour is summarised in Fig. 5(b) with a sketch of the potential distribution during the oscillation. We note that the domain boundary, which forms near the cathode, drifts a certain number of periods before it dissolves near the anode. [13]

The question of the asymmetry exhibited by sample 9/4 should also be addressed. As discussed earlier the current oscillations originate from an instability of the field distribution. Because the oscillations are only observed in lightly and moderately doped samples, it can be concluded that they are caused by an undersupply of electrons at the domain boundary. Clearly, the injected carriers play an important role in the formation of the domain boundary so that a slight asymmetry in the contact layers will result in a reduced carrier density at the domain wall. Given that the reverse bias current in the 9/4 sample is slightly higher than that for forward bias, it is concluded that the supplied electron density in the latter case is insufficient to form stable domains. The lower plateaus of sample 13.3/2.7 have not been investigated with time-resolved techniques. Time-integrating PL measurements, however, clearly show that the field distribution in these voltage regions is strongly inhomogeneous so that oscillations are also expected in these regions.

Thus, the existence of self-generated oscillations in semiconductor superlattices have ben found. Whether oscillations occur or it depends on the doping density, the injected carrier density and the drift velocity. The oscillation frequency depends primarily on the tunnelling probability. This is supported by the observations that (a) the oscillation frequency is higher in plateaus that involve higher tunnelling resonances and (b) the frequency increases with decreasing barrier width. Besides the nature of the NDV mechanism, an important difference to the Gunn effect is that the SL allows one to tune the position and the number of tunnelling maxima over a wide range by an appropriate change of the growth parameters. For Gunn diodes the important parameters are mainly the diode length and the doping density. It has been shown that the SL oscillation frequency can be significantly increased by reducing the barrier width. While higher frequencies can possibly be achieved by appropriately controlling the SL parameters, it remains to be seen that the instability allows frequencies beyond the GHz range. In this context it is noted that strongly coupled samples have recently been shown to exhibit THz Bloch oscillations [14]. While the oscillations underlying the present teaching are very different in nature it is possible that Bloch oscillations may constitute a frequency limit for the domain oscillations.

REFERENCES

[1] B.K. Ridley and T.B. Watkins, Proc. Phys. Soc. 78, 239 (1961).

[2] J.B. Gunn, Solid State Comm. 1, 88 (1963).

[3] L. Esaki and R. Tsu, IBM J. Res. Dev. 14, 61 (1970).

[4] R. F. Kazarinov and R.A. Suris, Fiz. Tekh. Poluprov. 5, 797 (1971) [Sov. Phys.-Semicond. 5, 707 (1971)].

[5] L. Esaki and L.L. Chang, Phys. Rev. Lett. 33. 495 (1974).

[6] H. Le Person, C. Minot, L. Boni, J. F. Palmier, and F. Mollot, Appl. Phys. Lett. 60, 2397 (1992).

[7] R. Merlin, S. H. Kwok, T. B. Norris, H. T. Grahn, K. Ploog, L. L. Bonilla, J. Galán, J. A. Cuesta, F. C. Martínez, and J. Molera, in *Proceedings of the 22nd International Conference on the Physics of Semiconductors*, edited by D. J. Lockwood (World Scientific, Singapore, 1995), 1039.

[8] H.T. Grahn, R. Klann, and W.W. Rühle, in *Proceedings of the 22nd International Conference on the Physics of Semiconductors*, edited by D. J. Lockwood (World Scientific, Singapore, 1995), 1169.

[9] S.H. Kwok, R. Merlin, H.T. Grahn, and K. Ploog, Phys. Rev. B 50, 2007 (1994).

[10] S.H. Kwok. H.T. Grahn, M. Ramsteiner, K. Ploog, F. Prengel, A. Wacker, E. Schöll, S. Murugkar, R. Merlin, Phys. Rev. B 51, 9943 (1995).

[11] J. Kastrup, H.T Grahn. K. Ploog, F. Prengel. A. Wacker, and E. Schöll, Appl. Phys. Lett. 65, 1808 (1994).

[12] H.T. Grahn, H. Schneider, and K. von Klitzing, Phys. Rev. B 41, 1890 (1990).

[13] H.T. Grahn, J. Kastrup. K. Ploog, L.L. Bonilla. J. Galán, M. Kindelan, and M. Moscoso, Jpn. J. Appl. Phys. 34. Part 1 No. 8B (1995).

[14] J. Feldmann, K. Leo, J. Shah. D.A.B. Miller, J. E. Cunningham. T. Meier, G. von Plessen, A. Schulze, P. Thomas. and S. Schmitt-Rink, Phys. Rev. B 46, 7252 (1992).

**Claims**

1. Semiconductor superlattice oscillator comprising a semiconductor substrate (10) having, in sequence, a first N-layer (12) deposited directly or indirectly on the substrate (10), a superlattice structure (14) comprising alternating pairs of semiconductor layers of materials of first and second band gaps deposited on said N-layer (12), there being preferably a minimum of ten and in particular more than twenty such layer pairs, and a second N-layer (16) deposited on said superlattice structure (14), further layers being optionally also possible, there being first and second means (18, 20) for contacting said first and second layers (12, 16) respectively, **characterised in that** the superlattice layers are of a thickness such that energy quantisation in the form of subbands and resonant tunnelling between subbands of adjacent well layers takes place; and **in that** the doping density in the well layers is selected so that sustained oscillations of the field distribution inside the superlattice structure (14), and thus of the output current, occur.

2. Semiconductor oscillator in accordance with claim 1, **characterised in that** the doping is effected within a centre region of each well layer, not however in the regions directly adjacent the barrier layers.

3. Semiconductor oscillator in accordance with claim 1, **characterised in that** means (22-26) are provided for applying a potential difference to said first and second contacting means (18, 20) of a size such that sustained oscillations due to resonant tunnelling takes place.

4. Semiconductor oscillator in accordance with any one of the preceding claims, wherein the semiconductor material system chosen is any one of the material systems where a periodic modulation of the conduction band is obtainable, e.g. a III-V or a II-VI compositional compound semiconductor.

5. Semiconductor oscillator in accordance with any one of the preceding claims, **characterised in that** a capacitor is provided for coupling out the oscillation of the semiconductor oscillator and is connected by one plate to one of said first and second contact means (18, 20) and by its other plate to a circuit for further processing of the oscillation.

6. Semiconductor oscillator in accordance with any one of the preceding claims, **characterised in that** means is provided for varying the applied voltage to tune the frequency of the oscillation.

7. Method of manufacturing a semiconductor superlattice oscillator comprising a semiconductor substrate (10) having, in sequence, a first N-layer (12) deposited directly or indirectly on the substrate (10), a superlattice structure (14) comprising alternating pairs of semiconductor layers of materials of first and second band gaps deposited on said N-layer (12), there being preferably a minimum of ten and in particular more than twenty such layer pairs, and a second N-layer (16) deposited on said superlattice structure, there being first and second means (18, 20) of contacting said first and second layers (12, 16) respectively, **characterised in that** the thickness of the superlattice layers is selected such that energy quantisation in the form of subbands and resonant tunnelling between subbands of adjacent well layers takes place; and **in that** the doping density in the well layers is selected so that sustained oscillations of the field distribution inside the superlattice structure (14), and thus of the output current, occurs.

8. Method in accordance with claim 7, **characterised in that** the doping is effected within a centre region of each well layer, not however in the regions directly adjacent the barrier layers.

9. Method of operating a semiconductor superlattice oscillator comprising a semiconductor substrate (10) having, in sequence, a first N-layer (12) deposited directly or indirectly on the substrate (10), a superlattice structure (14) comprising alternating pairs of semiconductor layers of materials of first and second band gaps deposited on said N-layer (12), there being preferably a minimum of ten and in particular more than twenty such layer pairs, the thickness of said superlattice layers being selected such that energy quantisation in the form of subbands and resonant tunnelling between subbands of adjacent well layers takes place, and the doping density in the well layers being selected so as to allow for the occurrence of sustained oscillations of the field distribution inside the superlattice structure (14), and a second N-layer (16) deposited on said superlattice structure (14), there being first and second means of contacting said first and second layers (12,16) respectively, **characterised in that** a potential difference is applied to said first and second contacting means (18,20) of a size such that sustained oscillations due to resonant tunnelling takes place.

10. Method in accordance with claim 9, **characterised in that** the frequency of the self-sustained oscillation is tuned by variation of the applied potential difference.

**Patentansprüche**

1. Halbleiterübergitteroszillator umfassend ein Halbleitersubstrat (10) mit, in der Reihenfolge, eine erste N-Schicht (12), die direkt oder indirekt auf dem Substrat (10) abgeschieden ist, einer auf der N-Schicht (12) abgeschiedenen Übergitterstruktur (14), die alternierende Paare von Halbleiterschichten aus Materialien mit einer ersten und einer zweiten Bandlücke umfasst, wobei es vorzugsweise ein Minimum von zehn und insbesondere mehr als zwanzig solcher Schichtpaare gibt, und einer zweiten N-Schicht (16), die auf der Übergitterstruktur (14) abgeschieden ist, wobei auch weitere Schichten optional möglich sind, wobei es ein erstes und ein zweites Mittel (18, 20) zum Kontaktieren jeweils der ersten und der zweiten Schicht (12, 16) gibt, **dadurch gekennzeichnet, dass** die Übergitterschichten eine Dicke derart aufweisen, dass eine Energiequantisierung in der Form von Subbändem und resonantes Tunneln zwischen Subbändern benachbarter Topfschichten stattfindet, und dass die Dotierdichte in den Topfschichten so gewählt ist, dass aufrechterhaltene Oszillationen der Feldverteilung im Inneren der Übergitterstruktur (14) und somit des Ausgangsstroms auftreten.

2. Halbleiteroszillator nach Anspruch 1, **dadurch gekennzeichnet, dass** die Dotierung innerhalb eines zentralen Bereiches jeder Topfschicht, nicht aber in den Bereichen bewirkt ist, die direkt an die Barrierenschichten angrenzen.

3. Halbleiteroszillator nach Anspruch 1, **dadurch gekennzeichnet, dass** Mittel (22 - 26) vorgesehen sind, um einen Potentialunterschied einer solchen Größe an das erste und zweite Kontaktmittel (18, 20) anzulegen, dass aufrechterhaltene Oszillationen aufgrund von resonantem Tunneln stattfinden.

4. Halbleiteroszillator nach einem der vorherigen Ansprüche, wobei das ausgewählte Halbleitermaterialsystem ein beliebiges der Materialsysteme ist, bei denen eine periodische Modulation des Leitungsbandes erreichbar ist, zum Beispiel ein Verbindungshalbleiter mit einer III-V-oder II-VI-Zusammensetzung.

5. Halbleiteroszillator nach einem der vorherigen Ansprüche, **dadurch gekennzeichnet, dass** ein Kondensator vorgesehen ist, um die Oszillation des Halbleiteroszillators auszukoppeln, und dass der Kondensator durch eine Platte mit einem der ersten und zweiten Kontaktmittel (18, 20) und durch seine andere Platte mit einer Schaltung für eine weitere Verarbeitung der Oszillation verbunden ist.

6. Halbleiteroszillator nach einem der vorherigen Ansprüche, **dadurch gekennzeichnet, dass** ein Mittel zur Veränderung der angelegten Spannung vorgesehen ist, um die Frequenz der Oszillation einzustellen.

7. Verfahren zur Herstellung eines Halbleiterübergitteroszillators, der ein Halbleitersubstrat (10) umfasst mit, in der Reihenfolge, einer ersten N-Schicht (12), die direkt oder indirekt auf dem Substrat (10) abgeschieden ist, einer auf der N-Schicht (12) abgeschiedenen Übergitterstruktur (14), die alternierende Paare von Halbleiterschichten aus Materialien mit einer ersten und einer zweiten Bandlücke umfasst, wobei es vorzugsweise ein Minimum von zehn und insbesondere mehr als zwanzig solche Schichtpaare gibt, und einer zweiten N-Schicht (16), die auf der Übergitterstruktur abgeschieden ist, wobei es ein erstes und ein zweites Mittel (18, 20) zum Kontaktieren jeweils . der ersten und der zweiten Schicht (12, 16) gibt, **dadurch gekennzeichnet, dass** die Dicke der Übergitterschichten derart gewählt wird, dass eine Energiequantisierung in der Form von Subbändern und resonantes Tunneln zwischen Subbändern benachbarter Topfschichten stattfindet, und dass die Dotierdichte in den Topfschichten so gewählt wird, dass aufrechterhaltene Oszillationen der Feldverteilung im Inneren der Übergitterstruktur (14) und somit des Ausgangsstroms auftreten.

8. Verfahren nach Anspruch 7, **dadurch gekennzeichnet, dass** die Dotierung innerhalb eines zentralen Bereiches jeder Topfschicht, nicht aber in den Bereichen bewirkt wird, die direkt an die Barrierenschichten angrenzen.

9. Verfahren zum Betreiben eines Halbleiterübergitteroszillators, der ein Halbleitersubstrat (10) umfasst mit, in der Reihenfolge, einer ersten N-Schicht (12), die direkt oder indirekt auf dem Substrat (10) abgeschieden ist, einer auf der N-Schicht (12) abgeschiedenen Übergitterstruktur (14), die alternierende Paare von Halbleiterschichten aus Materialien mit einer ersten und einer zweiten Bandlücke umfasst, wobei es vorzugsweise ein Minimum von zehn und insbesondere mehr als zwanzig solche Schichtpaare gibt, wobei die Dicke der Übergitterschichten so gewählt wird, dass eine Energiequantisierung in der Form von Subbändern und resonantes Tunneln zwischen Subbändern benachbarter Topfschichten stattfindet, und wobei die Dotierdichte in den Topfschichten so gewählt wird, dass sie das Auftreten von aufrechterhaltenen Oszillationen der Feldverteilung im Inneren der Übergitterstruktur (14) erlaubt, und einer zweiten N-Schicht (16), die auf der Übergitterstruktur (14) abgeschieden ist, wobei es ein erstes und ein zweites Mittel zum Kontaktieren jeweils der ersten und der zweiten Schicht (12, 16) gibt, **dadurch gekennzeichnet, dass** ein Potentialunterschied einer solchen Größe an das erste und zweite Kontaktmittel (18, 20) angelegt wird, dass aufrechterhaltene Oszillationen aufgrund von resonantem Tunneln stattfinden.

10. Verfahren nach Anspruch 9, **dadurch gekennzeichnet, dass** die Frequenz der selbst aufrechterhaltenen Oszillation durch eine Veränderung des angelegten Potentialunterschieds eingestellt wird.

**Revendications**

1. Oscillateur à surstructure semiconductrice comportant un substrat semiconducteur (10) ayant, séquentiellement, une première couche N (12) déposée directement ou indirectement sur le substrat (10), une surstructure (14) comportant des paires alternées de couches semiconductrices de matières de première et seconde bandes interdites déposées sur ladite couche N (12), avec avantageusement un minimum de dix et en particulier plus de vingt de ses paires de couches, et une seconde couche N (16) déposée sur ladite surstructure (14), d'autres couches étant également possibles facultativement, des premier et second moyens (18, 20) étant destinés à entrer en contact avec lesdites première et seconde couches (12, 16) respectivement, **caractérisé en ce que** les couches de surstructure sont d'une épaisseur telle qu'une quantification d'énergie sous la forme de sous-bandes et un effet tunnel résonnant entre sous-bandes de couches de puits adjacentes ont lieu ; et **en ce que** la densité de dopage dans les couches de puits est sélectionnée de façon que des oscillations entretenues dans la distribution de champ à l'intérieur de la surstructure (14) et, par conséquent, du courant de sortie, aient lieu.

2. Oscillateur à semiconducteur selon la revendication 1, **caractérisé en ce que** le dopage est effectué dans une région centrale de chaque couche de puits, mais non dans les régions directement adjacentes aux couches d'arrêt.

3. Oscillateur à semiconducteur selon la revendication 1, **caractérisé en ce que** des moyens (22, 26) sont prévus pour appliquer une différence de potentiel auxdits premier et second moyens de contact (18, 20) d'une dimension telle que des oscillations entretenues dues à un effet tunnel résonnant ont lieu.

4. Oscillateur à semiconducteur selon l'une quelconque des revendications précédentes, dans lequel le système de matière semiconductrice choisi est l'un quelconque des systèmes de matières où une modulation périodique de la bande de conduction peut être obtenue, par exemple un semi-conducteur composé ayant une composition III-V ou II-VI.

5. Oscillateur à semiconducteur selon l'une quelconque des revendications précédentes, **caractérisé en ce qu'**un condensateur est prévu pour délivrer en sortie par couplage l'oscillation de l'oscillateur à semiconducteur et est connecté par une armature à l'un desdits premier et second moyens de contact (18, 20) et par son autre armature à un circuit destiné à un autre traitement de l'oscillation.

6. Oscillateur à semiconducteur selon l'une quelconque des revendications précédentes, **caractérisé en ce qu'**un moyen est prévu pour faire varier la tension appliquée afin d'accorder la fréquence de l'oscillation.

7. Procédé de fabrication d'un oscillateur à surstructure à semiconducteur comportant un substrat semi-conducteur (10) ayant, séquentiellement, une première couche N (12) déposée directement ou indirectement sur le substrat (10), une surstructure (14) comportant des paires alternées de couches semiconductrices de matières de première et seconde bandes interdites déposées sur ladite couche N (12), avec un minimum de dix et en particulier plus de vingt de ces paires de couches, et une seconde couche N (16) déposée sur ladite surstructure, des premier et second moyens (18, 20) étant destinés à entrer en contact avec lesdites première et seconde couches (12, 16), respectivement, **caractérisé en ce que** l'épaisseur des couches de surstructure est sélectionnée de façon qu'une quantification d'énergie sous sa forme de sous-bandes et un effet tunnel résonnant entre sous-bandes de couches de puits adjacentes aient lieu ; et **en ce que** la densité de dopage dans les couches de puits est sélectionnée afin que des oscillations entretenues dans la distribution de champ à l'intérieur de la surstructure (14) et, par conséquent, du courant de sortie, aient lieu.

8. Procédé selon la revendication 7, **caractérisé en ce que** le dopage est effectué dans une région centrale de chaque couche de puits, mais non dans les régions directement adjacentes aux couches d'arrêt.

9. Procédé pour faire fonctionner un oscillateur à surstructure à semiconducteur comportant un substrat semi-conducteur (10) ayant, séquentiellement, une première couche N (12) déposée directement ou indirectement sur le substrat (10), une surstructure (14) comportant des paires alternées de couches semiconductrices de matières de première et seconde bandes interdites déposées sur ladite couche N (12), avec un minimum de dix et en particulier plus de vingt de ces paires de couches, l'épaisseur desdites couches de surstructure étant sélectionnée de façon qu'une quantification d'énergie sous la forme de sous-bandes et un effet tunnel résonnant entre sous-bandes de couches de puits adjacents aient lieu, et la densité de dopage dans les couches de puits étant sélectionnée afin de permettre l'apparition d'oscillations entretenues dans la distribution de champ à l'intérieur de la surstructure (14), et une seconde couche N (16) déposée sur ladite surstructure (14), des premier et second moyens étant destinés à entrer en contact avec lesdites première et seconde couches (12, 16), respectivement, **caractérisé en ce qu'**une différence de potentiel est appliquée auxdits premier et second moyens (18, 20) de contact d'une dimension telle que des oscillations entretenues dues à un effet tunnel résonnant ont lieu.

10. Procédé selon la revendication 9, **caractérisé en**

**ce que** la fréquence de l'oscillation entretenue est accordée par variation de la différence de potentiel appliquée.

Sample setup with a frequency generator based on the 13.3/2.7 superlattice in a 20 GHz network. The presented data was recorded by triggering a sampling oscilloscope at HF-out 2 on the signal from HF-out 1.

FIG. 1A

SAMPLE STRUCTURE FOR 13.3/2.7 SAMPLE

$n^+$-GaAs substrate

| 90 | nm | GaAs:Si | $n = 1 \times 10^{18} cm^{-3}$ |
|---|---|---|---|
| 175 | nm | $Al_xGa_{1-x}As$:Si | $x = 0.0 \rightarrow 0.5$ |
| 300 | nm | $Al_{0.5}Ga_{0.5}As$:Si | $n = 1 \times 10^{18} cm^{-3}$ |
| 55 | nm | $Al_xGa_{1-x}As$:Si | $n\downarrow$ $x = 0.5 \rightarrow 0.0$ |
| 25 | nm | GaAs | |
| 2.7 | nm | AlAs | |
| 13.3 | nm | GaAs:Si | $\}$ x 50 $n = 8 \times 10^{15} cm^{-3}$ |
| 2.7 | nm | AlAs | |
| 25 | nm | GaAs | |
| 55 | nm | $Al_xGa_{1-x}As$:Si | $n\uparrow$ $x = 0.0 \rightarrow 0.5$ |
| 720 | nm | $Al_{0.5}Ga_{0.5}As$:Si | $n = 2 \times 10^{18} cm^{-3}$ |
| 50 | nm | GaAs:Si | |
| | | Si- | $\delta$-doped |
| 6 | nm | GaAs:Si | |

FIG. 1B

FIG. 2

FIG. 3A

FIG. 3B

FIG. 3C

FIG. 4

EP 0 759 640 B1

FIG. 5a

FIG.5b

$F_{11}$

FIG. 6A

$F_{12}$

FIG. 6B

FIG. 7A

FIG. 7B

FIG. 8

13.3/2.7 GaAs/AlAs

Higher Temperatures

Schematic drift velocity vs field characteristic

up to 1.2 GHz

up to 500 MHz

up to 25 MHz

295 K

200 K

100 K

4 K

Voltage [V]

Current [A]

FIG. 9

13.3/2.7 GaAs/AlAs

Temperature dependency of the frequency

FIG. 10

EP 0 759 640 B1

13.3/2.7 GaAs/AlAs

Oscillations at room temperature (T = 295 K)

FIG. 11

EP 0 759 640 B1